(19) Europäisches Patentamt
European Patent Office
Office européen des brevets

(11) **EP 3 007 211 A1**

(12) **EUROPEAN PATENT APPLICATION**
published in accordance with Art. 153(4) EPC

(43) Date of publication:
**13.04.2016 Bulletin 2016/15**

(51) Int Cl.:
***H01L 21/304*** *(2006.01)*

(21) Application number: **14803829.2**

(22) Date of filing: **22.05.2014**

(86) International application number:
**PCT/JP2014/063578**

(87) International publication number:
**WO 2014/192631 (04.12.2014 Gazette 2014/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.05.2013 JP 2013115704**

(71) Applicant: **Mitsui Chemicals Tohcello, Inc.**
**Tokyo 101-8485 (JP)**

(72) Inventors:
• **USUGI Shinichi**
**Tokyo 105-7117 (JP)**

• **IGARASHI Kouji**
**Nagoya-shi**
**Aichi 457-0801 (JP)**
• **MORIMOTO Akimitsu**
**Nagoya-shi**
**Aichi 457-0801 (JP)**

(74) Representative: **Hoffmann Eitle**
**Patent- und Rechtsanwälte PartmbB**
**Arabellastraße 30**
**81925 München (DE)**

(54) **ELECTRONIC MEMBER PEELING METHOD AND LAMINATED BODY**

(57) Provided is a method of peeling an electronic member (16) from a laminate (10) composed of the electronic member (16) adhered to a supporting substrate (12) via an adhesive film (14), the adhesive film (14) having a self-peeling adhesive layer (17) on a surface located on the side of the supporting substrate (12) and an exposed region A in at least one part of a surface (14a) which is located on the side of the electronic member (16). The method includes: a step of reducing adhesive strength between the supporting substrate (12) and the self-peeling adhesive layer (17) in the region A by applying energy on the region A; a step of removing the supporting substrate (a) from the laminate by further applying energy on the region and thus further reducing the adhesive strength reduced in the prior step between the supporting substrate (a) and the self-peeling adhesive layer from a starting point of the interface between the supporting substrate (a) and the self-peeling adhesive layer; and a step of peeling the electronic member (16) from the laminate by removing the adhesive film (14) from the electronic member (16).

[FIG. 1]

## Description

TECHNICAL FIELD

The present invention relates to a method of easily peeling an electronic member without causing any damage thereto by applying energy, and a laminate.

BACKGROUND ART

Conventionally, in a manufacturing process of the IC chip for instance, in the case of polishing a thick wafer cut out from a high purity silicon single crystal or the like to a predetermined thickness to manufacture a thin wafer, it is proposed to reinforce the thick wafer by adhering a supporting substrate thereto in order to facilitate work efficiency. While the thick wafer and the supporting substrate need to be firmly adhered to each other during the polishing process, the obtained thin wafer is required to be peeled off from the supporting substrate without any damage once the polishing process is finished.

Thus, a method of adhering plate-like materials to each other and then later, easily peeling off one plate-like material without damage is being sought.

As a peeling method for example, peeling by applying a physical force may be considered. However, there are cases in which a serious damage is incurred on an adhered object when the adhered object is fragile.

Another method of peeling can be considered using a solvent for dissolving the adhesive. This method too, however, cannot be used in the case where the adhered object is prone to corrosion by the solvent.

As such, there was a problem that the stronger the adhesive force of the adhesive used for temporal adhesion is, the more difficult it is for the adhered object to be peeled off without being damaged.

In order to adhere plate-like materials to each other, and then later easily peel off one plate-like material therefrom without causing any damage, it is proposed to use adhesives, of which the adhesive strength is lowered or lost through application of energy, such as heat, light, vibration and ultrasonic waves. Suggested adhesives of which the adhesive strength is lowered or lost with the application of energy include an adhesive including a gas generating component, an adhesive including heat-expandable microspheres, and an adhesive of which the adhesive strength is lowered when an adhesive component is subjected to crosslinking reaction by application of energy (Patent Documents 1 to 8).

RELATED DOCUMENTS

PATENT DOCUMENTS

Patent Document 1: JP-A-H05-43851
Patent Document 2: JP-A-H11-166164
Patent Document 3: Japanese Patent No. 4238037
Patent Document 4: JP-A-2003-173993
Patent Document 5: Japanese Patent No. 5006497
Patent Document 6: JP-A-2003-151940
Patent Document 7: JP-A-2001-200234
Patent Document 8: JP-A-2003-173989
Patent Document 9: U.S. Patent No. 8114766

SUMMARY OF THE INVENTION

PROBLEMS TO BE SOLVED BY THE INVENTION

However, even with a self-peeling adhesive, of which the adhesive strength is lowered by applying energy, the degree of reduction in the adhesive strength is small. Therefore, there is a problem that the adhered object cannot be sufficiently peeled off, or a large amount of energy is needed to peel off the adhered object, thereby slowing down the advancing speed of the production process, or the adhered object is affected by energy of the heat, light, and the like applied thereto for peeling.

The present invention has been made in view of the above circumstances, and an object thereof is to provide a method of easily peeling electronic members without any damage through application of energy, and a laminate which can be used in the method.

MEANS TO SOLVE THE PROBLEMS

The present invention is described hereinbelow.

[1] A method of peeling an electronic member (c) from a laminate composed of the electronic member (c) adhered to a supporting substrate (a) via an adhesive film (b), said adhesive film (b) having a self-peeling adhesive layer on a surface thereof located on the side of said supporting substrate (a) and an exposed region in at least one part of a surface thereof which is located on the side of said electronic member (c), the method including:

a step of reducing adhesive strength between said supporting substrate (a) and said self-peeling adhesive layer by applying energy on said exposed region;
a step of removing said supporting substrate (a) from the laminate by further applying energy on said region and thus further reducing the adhesive strength reduced in said prior step between said supporting substrate (a) and said self-peeling adhesive layer from a starting point of an interface between said supporting substrate (a) and said self-peeling adhesive layer; and
a step of peeling said electronic member (c) from the laminate by removing said adhesive film (b) from said electronic member (c).

[2] A method of peeling an electronic member according to [1], in which said energy is any one selected from heat, light, vibration, stress and ultrasonic waves.
[3] A method of peeling an electronic member according to [1] or [2], in which said exposed region in which said adhesive film (b) is exposed exists along the entire outer edge of said electronic member (c).
[4] A method of peeling an electronic member according to any one of [1] to [3], in which said electronic member (c) is a silicon wafer, a ceramic capacitor or a semiconductor package.
[5] A laminate including:

a supporting substrate (a);
an adhesive film (b); and
an electronic member (c) adhered to said supporting substrate (a) via said adhesive film (b),
in which said adhesive film (b) has a self-peeling adhesive layer on a surface thereof which is located on the side of said supporting substrate (a) and an exposed region in at least one part of a surface thereof which is located on the side of said electronic member (c).

ADVANTAGEOUS EFFECTS OF INVENTION

According to the present invention, it is possible to provide a method of easily peeling off an electronic member, which is an adhered object, from a supporting substrate without causing any damage to the electronic member, by applying energy such as heat, light, vibration, stress and ultrasonic waves, and a laminate which can be used in the method.

BRIEF DESCRIPTION OF THE DRAWING

The above-described objects and others, features and advantages shall become more apparent through preferred embodiments described hereunder and drawings below associated therewith.
[FIG. 1] FIGS. 1(a) to 1(d) are schematic cross-sectional views of a laminate and a procedural cross-sectional view of the method of peeling an electronic member of the present embodiment.
[FIG. 2] FIGS. 2(a) and 2(b) are schematic cross-sectional views of the laminate for explaining the effects of the present invention.
[FIG. 3] FIGS. 3(i) to 3(iii) are schematic cross-sectional views of the laminate for explaining the effects of the present invention.
[FIG. 4] FIG. 4 is a drawing for explaining the method of evaluating peeling property in Examples.

DESCRIPTION OF EMBODIMENTS

Hereinafter, embodiments of the present invention will be described with reference to the drawings. In the drawings, the same reference numerals are given to the same members, and the description thereof will not be repeated.

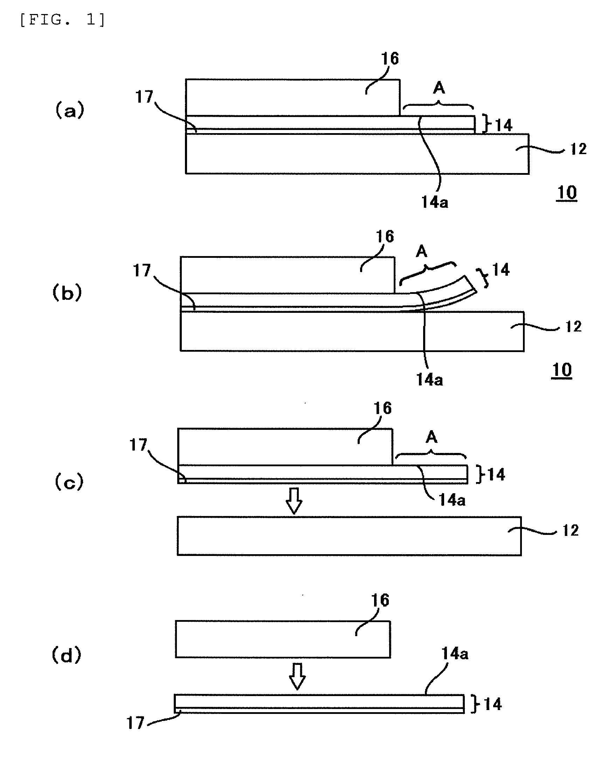

In the method of peeling an electronic member of the present embodiment, the electronic member (c) is peeled from a laminate composed of the electronic member (c) adhered to the supporting substrate (a) via the adhesive film (b). The method of peeling an electronic member of the present embodiment can be explained by a method of using a laminate (10) shown in FIG. 1(a). First of all, the laminate used in the present embodiment will be described below.

<Laminate>

The laminate of the present embodiment, as shown in FIG. 1(a), has an electronic member (16) adhered to a supporting substrate (12) via an adhesive film (14). The adhesive film (14) has a self-peeling adhesive layer (17) on the surface thereof which is located on the side of the supporting substrate (12) and a region A in which a surface 14a is exposed which is located on the side of the electronic member (16).

The region A in the present embodiment is present along the entire outer edge of the electronic member (16). In the region A, the larger the area of the surface 14a of the adhesive film 14 is, the lesser the total energy needed for peeling.

The area of the contact surface (equivalent to the area of the surface 14a) between the adhesive film (14) and the supporting substrate (12) in the region A is preferably 0.01 to 30%, more preferably 0.01 to 20%, and even more preferably 0.01 to 10% with respect to 100 % of the total area of the contact surface between the adhesive film (14) and the supporting substrate (12).

For example, in a resin sealing process using embedded Wafer Level Ball Grid Array(eWLB) technology in a semiconductor manufacturing process, with respect to an electronic member (16) having a diameter of 300 mm, the adhesive film (14) is preferably laminated so that ends thereof are on the outside of ends of the electronic member (16) by about 5 mm. Further, with respect to an electronic member (16) having a diameter of 450 mm, the adhesive film (14) is preferably laminated so that the ends thereof are further on the outer side of the ends of the electronic member (16) by about 5 mm. In this resin sealing process, the ends of the adhesive film (14) are preferably further on the outer side than the ends of the electronic member (16) by 2% or more with respect to a distance from the center to the end of the adhesive film (14) and the electronic member (16), and are more preferably further on the outer side than the ends of the electronic member (16) by 3% or more with respect to the distance from the center to the end of the adhesive film (14) and the electronic member (16).

[Electronic member (16) and supporting substrate (12)]

In this embodiment, the combination of the electronic member (16) and the supporting substrate (12) is appropriately selected in accordance with an object used in the method of peeling an electronic member of the present embodiment.

For instance, when the method of peeling an electronic member of the present embodiment is used in a wafer support system, the supporting substrate (12) is a hard substrate such as a glass substrate or a SUS substrate, while the electronic member (16) is a silicon substrate (silicon wafer).

When the method of peeling an electronic member of the present embodiment is used in ceramic capacitor manufacturing, the supporting substrate (12) is a plastic film or the like, and the electronic member (16) is a ceramic capacitor.

When using the method of peeling an electronic member of the present embodiment in a resin sealing process using eWLB technology, the supporting substrate (12) is a quartz substrate, a glass substrate, or the like, while the electronic member (16) is a semiconductor package.

[Adhesive film (14)]

The adhesive film (14) of the present embodiment is a film having adhesiveness on both sides, and has a self-peeling adhesive layer (17) (hereinafter simply referred to as adhesive layer (17)) in which the adhesive strength is lost or reduced by being subjected to an application of energy on one side thereof.

Examples of energy include light, heat, vibration, stress and ultrasonic waves. The type of energy used can be appropriately selected in accordance with the adhesive constituting the adhesive layer (17) and/or the peeling process.

Examples of an adhesive constituting the adhesive layer (17) include an adhesive which generates gas by application of energy, an adhesive including micro particles that expand with application of energy, and an adhesive in which crosslinking reaction is advanced by application of energy.

The adhesive film (14) of the present embodiment has an adhesive layer (17) on one side of a base film not shown in the drawing, and an adhesive layer on the other side thereof, not shown in the drawing. As such, the adhesive film (14) can have an adhesive layer having different properties between the surface in contact with the electronic member (16) and the surface in contact with the supporting substrate (12).

The adhesive and base film used for the adhesive film (14) may be composed of various materials depending on the application.

The base film constituting the adhesive film (14) is not particularly limited as long as it has flexibility and heat resistance and light resistance to a degree of not impairing the mechanical properties during the application of energy and the peeling process. General examples of such base film include, but are not limited to, paper; metal; and a plastic film or sheet, a sheet having a network structure, a sheet with holes composed of resin such as polyester, polyethylene, polypropylene, polycarbonate olefin-based resins, polyvinyl chloride, acrylic, ABS, polyethylene terephthalate (PET), nylon, urethane and polyimide. When it is desired to prevent light from reaching the adhesive layer (17), the base film may be made opaque by blending carbon black.

In order to enhance adhesive strength and holding strength with the adhesive layer (17), a base film may be used with its surface treated chemically or physically, which oxidizes the surface of the base film, such as chromic acid treatment, ozone exposure, flame exposure, high-pressure electric shock exposure, and ionizing radiation treatment.

The thickness of the base film is not particularly limited, but generally 500 $\mu$m or less (for example, 1 to 500 $\mu$m) is selected, and is preferably about 1 to 300 $\mu$m, and more preferably about 5 to 250 $\mu$m. The base film may be a single layer or a multi-layer.

The adhesive contained in the adhesive layer (17) is an adhesive that is decreased in or loses adhesive strength upon application of energy. Such adhesives are preferably selected from an adhesive containing gas generating components as mentioned in Patent Documents 1 to 8, an adhesive containing heat-expandable microspheres and an adhesive reduced in adhesive strength when adhesive components are subjected to crosslinking reaction upon the application of energy.

For example, azo compounds, azide compounds and Meldrum's acid derivatives are preferably used as gas-generating components. Also, those containing inorganic foaming agents such as ammonium carbonate, ammonium hydrogen carbonate, sodium hydrogen carbonate and ammonium nitrite, and organic foaming agents such as alkane chlorofluoride, hydrazine compounds, semicarbazide compounds, triazole compounds and N-nitroso compounds may be used. As heat-expandable microspheres, it is possible to use those containing substances showing heat expandable properties within shell-forming substances. As adhesives of which the adhesive strength is reduced through crosslinking reaction upon the application of energy, those containing a polymerizable oligomer in which the adhesive strength is reduced by crosslinking polymerization thereof may be used.

In addition, when using the adhesive in manufacture of a wafer support system or a ceramic capacitor, an adhesive with less adhesive residue is preferable in view of reusing the supporting substrate (12).

The adhesive used on the surface of the adhesive film (14) in contact with the electronic member (16) may be selected from conventionally known adhesives. In particular, the use of a pressure sensitive adhesive enables excellent workability in the adhesion process and the peeling process and leaves less adhesive residue, thereby improving the yield of the electronic member (16).

Examples of pressure sensitive adhesives include rubber-based pressure sensitive adhesives using rubber-based polymers such as natural rubber, polyisobutylene rubber, styrene-butadiene rubber, styrene-isoprene-styrene block copolymer rubber, regenerated rubber, butyl rubber, polyisobutylene rubber and NBR as base polymer; a silicone-based pressure sensitive adhesive; an urethane-based pressure sensitive adhesive; and an acrylic pressure sensitive adhesive. The mother agent may be composed of one kind or two or more kinds of components. Particularly preferred are acrylic pressure sensitive adhesives.

The production of acrylic pressure sensitive adhesives may be suitably selected from known methods such as solution polymerization, bulk polymerization, emulsion polymerization and various radical polymerizations. The resulting adhesive resin may be any of a random copolymer, a block copolymer and a graft copolymer.

<Method of peeling an electronic member>

In the present embodiment, peeling of the electronic member (16) is performed using the laminate (10) shown in FIG. 1(a).

The method of peeling an electronic member of the present embodiment includes the following steps.

Step 1: Reducing adhesive strength between the supporting substrate (12) and the self-peeling adhesive layer (17) in the region A by applying energy on the region A (FIG. 1(b)).

Step 2: Removing the supporting substrate (12) by further applying energy on the region A and thus further reducing the adhesive strength reduced in the prior step between the supporting substrate (12) and said self-peeling adhesive layer (17) from a starting point of the interface between said supporting substrate (a) and said self-peeling adhesive layer (17) (FIG. 1(c)).

Step 3: Peeling the electronic member (16) by removing the adhesive film (14) from the electronic member (16) (FIG. 1 (d)).

Each step is detailed hereinbelow.

[Step 1]

First, energy such as light, heat, vibration, stress and ultrasonic waves is applied to the region A of the laminate (10) shown in FIG. 1(a) in order for the adhesive strength to be reduced or lost in the interface between the adhesive layer (17) and the supporting substrate (12) of the adhesive film (14) (FIG. 1(b)). Adhesion in the interface should be reduced to less than one fifth of the initial value. In the region A, the entire adhesive film (14) may be peeled from the supporting substrate (12), partially peeled from the supporting substrate (12), or may be reduced in adhesive strength without being separated. FIG. 1(b) illustrates the state of the entire adhesive film (14) in the region A peeled from the supporting substrate (12).

In the region A, it is sufficient to have a part of the adhesive film (14) peeled from the supporting substrate (12) or lowered in the adhesive strength. With respect to 100% of contact area of the adhesive layer (17) and the supporting substrate (12), it is preferable that 10% or more by area ratio is peeled or the adhesive strength is lowered. The upper limit is 100% by area ratio. The area that is peeled or is lowered in adhesive strength is not limited to a specific position on the region A, and it may be a uniform range from the edge or may be a local range.

[Step 2]

As shown in FIG. 1(c), energy is further applied, and thus from a starting point of the interface between the supporting substrate (12) and the self-peeling adhesive layer (17) in the region A reduced in adhesion by Step 1, the adhesive strength between the supporting substrate (12) and the adhesive layer (17) is further lowered, thereby causing the supporting substrate (12) to be peeled from the adhesive film (14). As a result, the supporting substrate (12) and the adhesive film (14) are completely separated from each other.

In the adhesive film (14), since the surface in contact with the supporting substrate (12) is the adhesive layer (17) having self-peeling properties, the energy in Step 2 may be the same as or different from the energy in Step 2.

After Step 2, the electronic member (16) having the adhesive film (14) adhered thereto is obtained.

[Step 3]

The electronic member (16) can be peeled by removing the adhesive film (14) from the electronic member (16).

The adhesive used on the surface of the adhesive film (14) on which the electronic member (16) is adhered can be any commonly used adhesive in accordance with the material for the electronic member (16) and conditions of the production process, but it is also possible to use a self-peeling adhesive, similar to the adhesive used on the adhesive layer (17), of which the adhesion is reduced upon application of energy. In the case of using a self-peeling adhesive, it is possible to reduce the adhesion using the same or higher intensity of energy as that for the adhesive used on the surface where the supporting substrate (12) is adhered.

The method of removing the adhesive film (14) from the electronic member (16) can be suitably selected depending on the adhesive used on the surface of the adhesive film (14), on which the electronic member (16) is adhered. Peeling may be performed mechanically, or may be performed by reducing the adhesive strength of the adhesive.

In the configuration of the laminate (10), the adhesive strength of the adhesive layer (17) is sufficiently reduced by going through Steps 1 and 2, and the electronic member can be completely peeled off from the supporting substrate (12) with a small amount of energy. This, as a result, suppresses damage to the electronic member (16).

This is assumed to be due to the formation of a peeling starting point, formed by reducing the adhesive strength of the adhesive layer (17) at the interface between the supporting substrate (12) and the adhesive layer (17) in the region A by applying energy in the region A in advance in Step 1. For example, when the adhesive strength at an end of the adhesive film (14) in the region A is lowered in Step 1, air or ambient gas is likely to enter the interface between the supporting substrate (12) and the adhesive layer (17) from the end (the peeling starting point). Therefore, it is considered that less energy is needed for the peeling in Step 2. As a result, the total energy required for peeling is reduced.

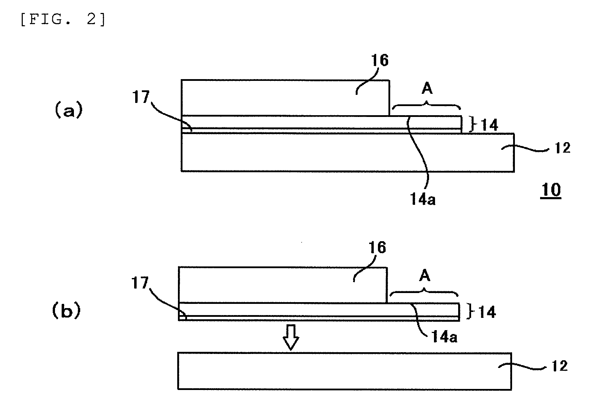

Even when the configuration of the laminate (10) of the present embodiment is employed, in order to perform peeling at the interface between the supporting substrate (12) and the adhesive film (14) without going through Steps 1 and 2 (FIGs. 2 (a) and 2(b)), a larger energy is needed than the total energy required for performing peeling through Steps 1 and 2.

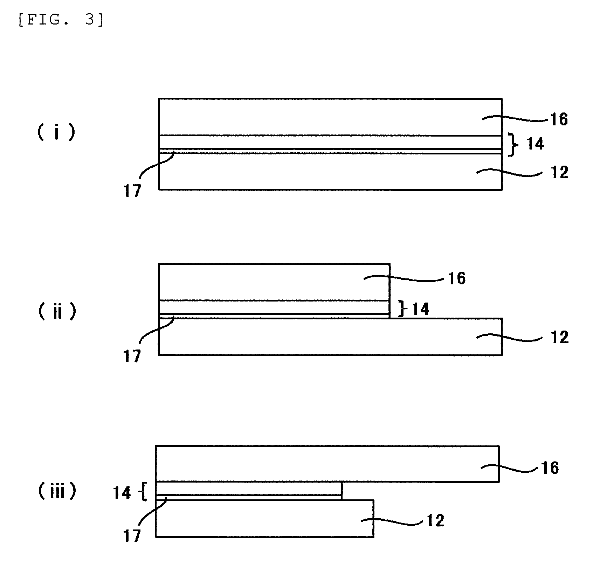

Since each laminate shown in FIGs. 3(i) to 3(iii) does not have the region A as in the present embodiment, Steps 1 and 2 cannot be applied to the laminates even when the electronic member (16) and the supporting substrate (12) are adhered via the adhesive film (14). In the case of the laminate in FIG. 3(i), a large amount of energy is required for peeling just as in FIGs. 2. The laminate in FIG. 3(ii) is not preferable, since it is necessary to match the ends of the adhesive film (14) and the ends of the electronic member (16), which is difficult in manufacturing process, and it cannot go through Steps 1 and 2. As for the laminate in FIG. 3(iii), the adhesive area is smaller, so it may not be possible to obtain a sufficient initial adhesive strength. Also, when using the laminate in FIG. 3(iii) in a resin sealing process in the semiconductor production, it results in leakage of the sealing resin, and thus, the laminate of FIG. 3(iii) is not preferable.

The peeling method of the present embodiment is suitable for producing various articles such as electric components including a ceramic capacitor, oscillator and a resistor, display devices including a liquid crystal cell display and a plasma display, and electronic components including a solar cell, a thermal head, a print circuit board (including a flexible type) and a semiconductor chip. A component, an article, or a material may be fixed or temporarily fixed as an adhered object, after which the adhered object is peeled off without being damaged. Alternatively, the method includes use as a carrier tape. In the use as a carrier tape, the carrier tape is in the form of adhering and holding an adhered object such as a semiconductor, an electronic member, or the like in a release layer at predetermined intervals during processing or shipping, and thus, the present method is an effective method for peeling the above adhered objects.

In particular, the method is suitable for an adhesive layer for a protective film or for fixing a wafer in a semiconductor process, and is suitably used in a Wafer Support System (WSS) and Embedded Wafer Level Packages (EWLP) and the like.

The material for the adhesive layer (17) and the type of energy applied can be suitably selected according to the purposes and manufacturing conditions. When the material of the supporting substrate (12) transmits light, it is effective to apply energy by light, and in the case vibration can be prevented from being unexpectedly applied during the process, it is effective to apply energy by vibration. Preferably, applying energy by heat is effective. In the case of using an adhesive in which adhesive strength is reduced or lost due to energy by heat, the adhesive in which the adhesion is reduced at a temperature higher than that of the heat applied during the manufacturing process should be used. It is also possible to apply a plurality of types of energy.

Having thus described embodiments of the present invention, these are illustrative of the present invention, and various other configurations may be adopted other than those described above.

It is sufficient that the region A in the present embodiment exist along a portion of the outer edge of the electronic member (16).

The present embodiment has been described by way of an example in which a self-peeling adhesive layer (17) is provided on the entire surface of the adhesive film (14) in contact with the supporting substrate (12), but it is sufficient that the self-peeling adhesive layer (17) is provided in the region A of the adhesive film (14).

In the present embodiment, the entire adhesive film (14) in contact with the supporting substrate (12) may be formed from the self-peeling adhesive layer (17).

EXAMPLES

Hereinafter, more detailed description of the present invention will be made through Examples, etc., but the scope of the invention is not limited thereto.

(Peeling property evaluation method)

A laminate composed of a supporting substrate (12) made of a 100 mm square plate (SUS304), an adhesive film (14) obtained from the below-described Production Examples, and an electronic member (16) made of a circular plate having a diameter of 80 mm (Ni-plated steel) was used to perform the evaluation in peeling properties of the supporting substrate (12).

An adhesive layer (17) side, in which the adhesive strength is reduced by applying energy, of the adhesive film (14) was adhered on the 100 mm square plate (SUS304) (the supporting substrate (12)). Then, the circular plate having a diameter of 80 mm (Ni-plated steel) (the electronic member (16)) was adhered to the other adhesive layer of the double-sided adhesive tape (the adhesive film (14)) to obtain a laminate. A measuring tool was attached to this laminate to carry out the peeling property evaluation of the supporting substrate (12). In Examples, in order to prevent peeling from occurring at the interface between the electronic member (16) and the adhesive film (14) in the course of measuring the peeling strength of the interface between the supporting substrate (12) and the adhesive film (14), a reinforced double-sided tape (product name: P-223, manufactured by Nitto Denko Corporation) was used for the measurement.

The measurement sample was placed on a heater block, was heated for a predetermined period of time, and the peeling property evaluation was carried out using a tensile tester.

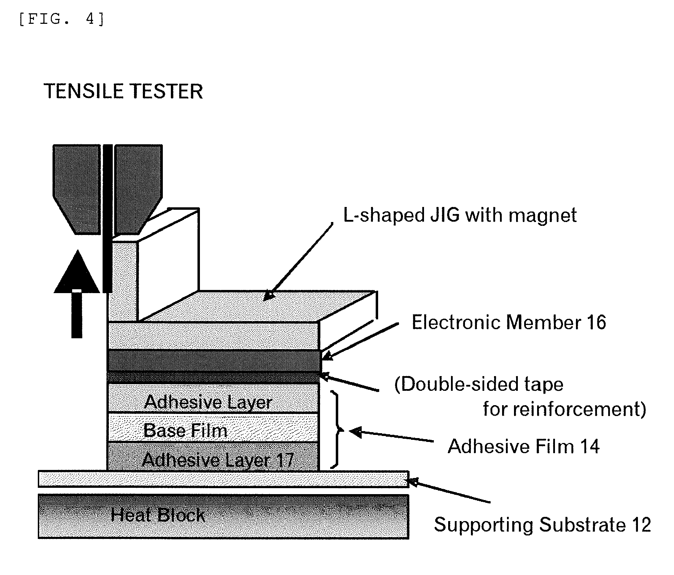

The laminate was fixed using a tool as shown in FIG. 4, and after performing the treatment described in Examples, the hook was pulled upwards by the tensile tester to perform the evaluation of peeling properties. The tensile tester uses an L-shaped tool having a magnet, and has a structure in which the magnet deviates at the tensile strength of 50 N or higher. When the magnet deviated, it was evaluated as "did not peel".

(Production Example 1)

A 500 ml four-necked flask was charged with 100 g of methylmalonic acid (manufactured by Tokyo Chemical Industry Co., Ltd.) and 100 g of acetic anhydride. After continued charging of 0.5 g of 98% sulfuric acid, 75 g of methyl ethyl ketone was added dropwise over an hour using a dropping funnel. After stirring for 24 hours at room temperature, 200 g of ethyl acetate and 300 g of distilled water were further added, and the organic layer was extracted using a separating funnel. The solvent was distilled off from the obtained organic layer using an evaporator, thereby obtaining 75 g of 2-ethyl-2,5-dimethyl-1,3-dioxane-4,6-dione. When the measurement of $H^1NMR$ (300MHz) was made, the following peak was obtained.

$\delta$ = 1.04-1.12 (m, 3H), 1.57-1.61 (m, 3H), 1.71 (s, 1.12H), 1.77 (s, 1.92H), 1.95-2.16 (m, 2H), 3.53-5.65 (m, 1H)

(Production Example 2)

A 500 ml four-necked flask was charged with 92 g of 2-ethyl-2,5-dimethyl-1,3-dioxane-4,6-dione synthesized in Production Example 1 and 100 g of dimethylformamide. After continued charging of 95 g of potassium carbonate, 97 g of 4-chloromethyl styrene was added dropwise over an hour using a dropping funnel. After stirring for 24 hours at 40°C, 400 g of ethyl acetate was added, and the generated solids were filtered using a Nutsche filter. Using 300 ml of distilled water, washing was performed twice in a separating funnel, and then the solvent was distilled off by an evaporator, thereby obtaining 132 g of 5-(p-styrylmethyl)-2-ethyl-2,5-dimethyl-1,3-dioxane-4,6-dione. When measurement was performed at $H^1NMR$ (300MHz), the following peak was obtained.

$\delta$ = 0.43 (t, 8.1Hz, 1.6H), 0.83 (s, 1.3H), 0.94 (t, 8.1Hz, 1.4H), 1.27 (q, 8 .1Hz, 1.2H), 1.57 (s, 1.7H), 1.75 (s, 3H), 1.80 (q, 8.1 Hz, 0.8H), 3.31 (s, 2H), 5.22 (d, 12.0Hz, 1H), 5.70 (d, 19.5Hz, 1H), 6.65 (dd, 12.0,19.5Hz, 1H), 7.16 (d , 9.0Hz, 2H), 7.31 (d, 9.0Hz, 2H)

(Production Example 3)

In a polymerization reactor, 150 parts by weight of deionized water and a polymerization initiator composed of 0.625 parts by weight of 4,4'-azobis-4-cyanovaleric acid (manufactured by Otsuka Chemical Co., Ltd., product name: ACVA), 18 parts by weight of n-butyl acrylate and 12 parts by weight of methyl methacrylate, 3 parts by weight of 2-hydroxyethyl methacrylate, 2 parts by weight of methacrylic acid and 1 part by weight of acrylamide, 1 part by weight of polytetramethylene glycol diacrylate (manufactured by NOF Corporation, product name: ADT-250) and 0.75 parts by weight of the benzene ring of an ammonium salt of sulfuric acid ester of polyoxyethylene nonylphenyl ether (mean of additional molar number of ethylene oxide: about 20) to which a polymerizable 1-propenyl group is introduced (manufactured by DSK Co., Ltd., product name: Aqualon HS-10) were charged, after which an 8-hour emulsion polymerization was performed at 70 to 72°C under stirring, from which an acrylic resin emulsion was obtained. This was neutralized with 9 wt% aqueous ammonia (pH=7.0) to obtain an acrylic-based adhesive S with the solid content of 42.5 wt% (acrylic adhesive S is a pressure sensitive adhesive).

(Production Example 4)

Into a 500 ml four-necked flask, 15 g of 5-(p-styrylmethyl)-2-ethyl-2,5-dimethyl-1,3-dioxane-4,6-dione synthesized in Production Example 2, 20 g of butyl acrylate, 63 g of 2-ethylhexyl acrylate, 2 g of methacrylic acid and 100 g of ethyl acetate were added, and were mixed at room temperature. Furthermore, 0.2 g of 2,2'-azobis valeronitrile was added, and the mixture was heated to 75°C and continuously stirred for 10 hours, from which an acrylic adhesive A having a molecular weight of 300,000 was obtained (acrylic-based adhesive A is a self-peeling adhesive). The glass transition point measured by differential scanning calorimetry (manufactured by Shimadzu Corporation, DSC-60) was 14°C.

(Production Example 5)

100 parts by weight of the acrylic adhesive S obtained from Production Example 3 was collected, to which 9 wt% aqueous ammonia was further added to adjust the pH to 9.5. Then, 0.8 parts by weight of an epoxy crosslinking agent (manufactured by Nippon Shokubai Co., Ltd., product name: Chemitite Pz-33) was added to obtain an adhesive coating liquid.

The resulting adhesive coating liquid was applied on a PET film, of which the surface is release-treated, using an applicator, to obtain a 10 μm thick dry film, which was heated at 120°C for 5 minutes to dry the coating liquid. Then, the film was adhered to each of both sides of the PET film, which is the base film.

Furthermore, through curing at 60°C for 3 days, the double-sided adhesive film 1 was obtained (pressure sensitive adhesive/ base film/ pressure sensitive adhesive).

(Production Example 6)

100 parts by weight of the acrylic adhesive A obtained from Production Example 4, 2 parts by weight of an epoxy compound (manufactured by Mitsubishi Gas Chemical Company, Inc. , TETRAD-C) and 50 parts by weight of ethyl acetate were added to obtain an adhesive coating liquid.

The resulting adhesive coating liquid was applied on a PET film, of which the surface is release-treated, using an applicator, to obtain a 10 μm thick dry film which was heated at 120°C for 5 minutes to dry the coating liquid. Then, the film was adhered to the surface of the PET film.

Furthermore, 100 parts by weight of the acrylic adhesive S obtained from Production Example 3 was collected, to which 9 wt% aqueous ammonia was added to adjust the pH to 9.5. Then, 0.8 parts by weight of an epoxy crosslinking agent (manufactured by Nippon Shokubai Co., Ltd., product name: Chemitite Pz-33) was added to obtain an adhesive coating liquid.

The resulting adhesive coating liquid was applied on a PET film, of which the surface is release-treated, using an applicator, to obtain a 10 μm thick dry film which was heated at 120 °C for 5 minutes to dry the coating liquid. Then, the film was adhered to the other side of the surface on which a film of acrylic adhesive A on the PET film was adhered.

Further, through curing at 60°C for 3 days, the double-sided adhesive film 2 was obtained (self-peeling adhesive/ base film/ pressure sensitive adhesive).

(Example 1)

The acrylic adhesive A side of the double-sided adhesive film 2 cut into a circle having a diameter of 84 mm was adhered on a 100 mm square plate (SUS304). Then, a circular plate with a diameter of 80 mm (Ni-plated steel) was adhered to the other side of the double-sided adhesive film 2 to obtain a laminate.

The laminate was attached with a measuring tool as shown in FIG. 4 to obtain a measurement sample.

In the region A of the double-sided adhesive film, the area on which the acrylic adhesive A and the 100 mm square plate are adhered was peeled 100% in area ratio using a spatula, and was heated at 210°C for 60 seconds on a heater block as shown in FIG. 4. Thereafter, evaluation of peeling properties was performed using the tensile tester. The evaluation results are shown in Table 1.

(Example 2)

The acrylic adhesive A side of the double-sided adhesive film 2 cut into a circle having a diameter of 86 mm was adhered on a 100 mm square plate (SUS304). Then, a circular plate with a diameter of 80 mm (Ni-plated steel) was adhered to the other side of the double-sided adhesive film 2 to obtain a laminate.

A measuring tool was attached to the laminate as shown in FIG. 4 to obtain a measurement sample.

In the region A of the double-sided adhesive film, the area on which the acrylic adhesive A and the 100 mm square plate are adhered was peeled 100% in area ratio by spatula, and was heated at 210°C for 60 seconds on a heater block as shown in FIG. 4 to perform the evaluation of peeling properties with the tensile tester. The evaluation results are shown in Table 1.

(Comparative Example 1)

The acrylic adhesive S side of the double-sided adhesive film 1 cut into a circle having a diameter of 84 mm was adhered on a 100 mm square plate (SUS304). Then, a circular plate with a diameter of 80 mm (Ni-plated steel) was adhered to the other side of the double-sided adhesive film 1 to obtain a laminate.

A measuring tool was attached to the laminate as shown in FIG. 4 to obtain a measurement sample.

The measurement sample was heated at 210°C for 60 seconds on a heater block as shown in FIG. 4 to perform the evaluation of peeling properties with the tensile tester. The evaluation results are shown in Table 1.

(Example 3)

An adhesive layer side containing heat-expandable microspheres of a double-sided adhesive film Revalpha 3195V (manufactured by Nitto Denko Corporation, a self-peeling adhesive film), cut into a circle having a diameter of 90 mm, was bonded on a 100 mm square plate (SUS304). A circular plate having a diameter of 80 mm (Ni-plated steel) was adhered to the other side of the adhesive layer containing heat-expandable microspheres of Revalpha.

A measuring tool was attached to the laminate as shown in FIG. 4 to obtain a measurement sample.

The measurement sample was heated at 210°C for 20 seconds on a heater block. In the region A of the double-sided adhesive film, it was confirmed that the area on which the adhesive layer containing the heat-expandable microspheres and the 100 mm square plate are adhered was peeled 100% in area ratio. Then, it was further heated at 210°C for 10 seconds to perform the peeling property evaluation with the tensile tester. The evaluation results are shown in Table 1.

Table 1

|  | Type of double-sided adhesive film | Diameter of double-sided adhesive film (mm) | Peeling Property Evaluation |
|---|---|---|---|
| Example 1 | Double-sided adhesive film 2 | 84 | Peeled |
| Example 2 | Double-sided adhesive film 2 | 86 | Peeled |
| Example 3 | Revalpha | 90 | Peeled |
| Comparative Example 1 | Double-sided adhesive film 1 | 84 | Did not peel |

(Production Example 7)

A four-necked flask of 500 ml was added with 10 g of 5-(p-styrylmethyl)-2-ethyl-2,5-dimethyl-1,3-dioxane-4,6-dione synthesized in Production Example 2, 20 g of butyl acrylate, 68 g of 2-ethylhexyl acrylate, 2 g of methacrylic acid and 100 g of ethyl acetate, and the mixture was mixed at room temperature. Further, 0.2 g of 2,2'-azobis valeronitrile was added, and the mixture was heated to 75°C and continuously stirred for 10 hours to obtain an acrylic adhesive B having the molecular weight of 300,000 (acrylic-based adhesive B is a self-peeling adhesive). The glass transition point measured by differential scanning calorimetry (manufactured by Shimadzu Corporation, DSC-60) was -5°C.

(Production Example 8)

100 parts by weight of the acrylic adhesive B obtained from Production Example 7, 2 parts by weight of an epoxy compound (manufactured by Mitsubishi Gas Chemical Company, Inc., TETRAD-C), 50 parts by weight of ethyl acetate and 5-(p-styrylmethyl)-2-ethyl-2,5-dimethyl-1,3-dioxane-4,6-dione synthesized obtained in Production Example 2 were added to obtain an adhesive coating liquid.

The resulting adhesive coating liquid was applied on a PET film, of which the surface is release-treated, using an applicator, to obtain a 10 μm thick dry film, which was heated at 120°C for 5 minutes to dry the coating liquid. Then, it was adhered to the PET film, which is the base film.

Then, 100 parts by weight of the acrylic adhesive S obtained from Production Example 3 was collected to which 9 wt% aqueous ammonia was added to adjust the pH to 9.5. Further, 0.8 parts by weight of an epoxy-based crosslinking agent (manufactured by Nippon Shokubai Co., Ltd., product name: Chemitite Pz-33) was added, thereby obtaining an adhesive coating liquid.

The resulting adhesive coating liquid was applied on a PET film, of which the surface is release-treated, using an applicator, to obtain a 10 μm thick dry film, which was heated at 120°C for 5 minutes to dry the coating liquid. It was then bonded to the other side of the surface on which the acrylic adhesive B film was adhered, on the PET film as a base film. The resultant was cured at 60°C for 3 days and the doubled-sided adhesive film 3 was obtained (self-peeling adhesive/base film/pressure sensitive adhesive).

(Example 4)

An acrylic adhesive B side of the double-sided adhesive film 3, cut into circle having a diameter of 82 mm, was bonded on a 100 mm square plate (SUS304). Then, a circular plate having a diameter of 80 mm (Ni-plated steel) was adhered to the other side of the double-sided adhesive film 3 to obtain a laminate.

A measuring tool was attached to the laminate as shown in FIG. 4 to obtain a measurement sample.

In the region A of the double-sided adhesive film 3, 100% in area ratio of the area on which the acrylic adhesive B and 100 mm square plate are adhered was peeled with a spatula by applying a force of 5.15 N, after which was heated at 210°C for 60 seconds on a heater block, and thereafter, peeling properties were evaluated using the tensile tester. The evaluation results are shown in Table 2.

The stress of "5.15 N" applied when peeling with a spatula was calculated as follows.

Peeling strength between the acrylic adhesive B of the double-sided adhesive film 3 and the 100 mm square plate (SUS304): 0.5 N / 25 mm

The outer circumference of the double-sided adhesive film 3: 82n mm

0.5 / 25 x 82$\pi$ = 5.15 N

Here, the total peeling strength (N) required for the peeling is the strength required for peeling the region A, that is, the sum of the stress when peeled with a spatula and the peeling strength measured with the tensile tester after heating on a heater block.

(Comparative Example 2)

The acrylic adhesive B side of the double-sided adhesive film 3 cut into a circle having a diameter of 82 mm was adhered on a 100 mm square plate (SUS304). Then, a circular plate with a diameter of 80 mm (Ni-plated steel) was adhered to the other side of the double-sided adhesive film 3 to obtain a laminate.

A measuring tool was attached to the laminate as shown in FIG. 4 to obtain a measurement sample. The measurement sample was heated at 210°C for 60 seconds on a heater block as shown in FIG. 4 to perform the evaluation of peeling properties with the tensile tester, but peeling did not occur, and the magnet deviated. The evaluation results are shown in Table 2.

Since peeling did not occur and the magnet was deviated, in the peeling properties evaluation, the total peeling strength (N) required for peeling is estimated to be 50 (N) or more.

(Comparative Example 3)

The acrylic adhesive B side of the double-sided adhesive film 3 cut into a circle having a diameter of 82 mm was adhered on a 100 mm square plate (SUS304). Then, a circular plate with a diameter of 80 mm (Ni-plated steel) was adhered to the other side of the double-sided adhesive film 3 to obtain a laminate.

A measuring tool was attached to the laminate to obtain a measurement sample.

The measurement sample was heated at 240°C for 120 seconds on a heater block, and thereafter, peeling properties were evaluated using the tensile tester. The evaluation results are shown in Table 2.

Unlike in Example 4, the region A was not peeled, so the total peeling strength (N) required for the peeling was the peeling strength measured with the tensile tester after heating on a heater block.

Table 2

| | Peeling strength in peeling property evaluation (N) | Strength required for peeling (N) |
|---|---|---|
| Example 4 | 25 | 30 |
| Comparative Example 2 | Did not peel | Over 50 |
| Comparative Example 3 | 45 | 45 |

From the results of Example 4 in Table 2, it was identified that only a small amount of energy is needed for peeling by going through Steps 1 and 2, but that it takes a large amount of energy to peel in one step as shown in Comparative Examples 2 and 3.

(Production Example 9)

Into a four-necked flask of 500 ml, 15 g of 5-(p-styrylmethyl)-2-ethyl-2,5-dimethyl-1,3-dioxane-4,6-dione synthesized in Production Example 2, 18 g of butyl acrylate, 64 g of 2-ethylhexyl acrylate, 2 g of methacrylic acid, 1 g of 2-hydroxyethyl methacrylate and 100 g of ethyl acetate were added, and were mixed at room temperature. Furthermore, 0.2 g of 2,2'-azobis valeronitrile was added, and the mixture was heated to 75°C and continuously stirred for 10 hours, from which an acrylic adhesive C having a molecular weight of 300,000 was obtained (acrylic-based adhesive C is a self-peeling adhesive). The glass transition point measured by differential scanning calorimetry (manufactured by Shimadzu Corporation, DSC-60) was 5°C.

(Production Example 10)

100 parts by weight of the acrylic adhesive C obtained from Production Example 9, 1 part by weight of epoxy compound (manufactured by Mitsubishi Gas Chemical Company, Inc., TETRAD-C), 50 parts by weight of ethyl acetate and 50 parts by weight of toluene were added to obtain an adhesive coating liquid.

The resulting adhesive coating liquid was applied on a PET film, of which the surface is release-treated, using an applicator, to obtain a 10 μm thick dry film, which was heated at 120 °C for 5 minutes to dry the coating liquid. Then, it was adhered to the PET film, which is the base film.

100 parts by weight of the acrylic adhesive S obtained from Production Example 3 was collected, to which 9 wt% aqueous ammonia was added to adjust the pH to 9.5. Then, 0.8 parts by weight of an epoxy crosslinking agent (manufactured by Nippon Shokubai Co. , Ltd., product name: Chemitite Pz-33) was added to obtain an adhesive coating liquid.

The resulting adhesive coating liquid was applied on a PET film, of which the surface is release-treated, using an applicator, to obtain a 10 μm thick dry film, which was heated at 120°C for 5 minutes to dry the coating liquid. Then, it was adhered to the other side of the side on which the acrylic adhesive C layer was bonded, on the PET film, which is the base film. Also, it was cured at 60°C for 3 days to obtain the double-sided adhesive film 4 (self-peeling adhesive/ base film/ pressure sensitive adhesive).

(Example 5)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

In the region A of the double-sided adhesive film 4, 100% in area ratio of the area on which the acrylic adhesive C and 100 mm square plate are adhered was peeled with a spatula by applying a force of 5.28 N, after which was heated at 210°C for 60 seconds on a heater block, and thereafter, peeling properties were evaluated using the tensile tester. The evaluation results are shown in Table 3.

The stress of "5.28 N" applied when peeling with a spatula was calculated as follows.

Peeling strength between the acrylic adhesive C of the double-sided adhesive film 4 and the 100 mm square plate (SUS304): 0.5 N/ 25 mm

The outer circumference of the double-sided adhesive film 4: 84n mm

$$0.5 / 25 \times 84\pi = 5.28 \text{ N}$$

Here, the total peeling strength (N) required for the peeling is the strength required for peeling the region A, that is, the sum of the stress when peeled with a spatula and the peeling strength measured with the tensile tester after heating on a heater block.

(Example 6)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

In the region A of the double-sided adhesive film 4, 75% in area ratio of the area on which the acrylic adhesive C and 100 mm square plate are adhered was peeled with a spatula by applying a force of 5 N. Out of the outer periphery of the region A of the double-sided adhesive film 4, the portion which was pulled with the tensile tester was not peeled, while the remaining area was peeled. After that, the laminate was heated at 210°C for 60 seconds on a heater block, and thereafter, peeling properties were evaluated using the tensile tester. The evaluation results are shown in Table 3.

The stress when peeling with a spatula was calculated by the same method as Example 5. Here, the total peeling strength (N) required for the peeling is the strength required for peeling the region A, that is, the sum of the stress when peeled with a spatula and the peeling strength measured with the tensile tester after heating on a heater block.

(Example 7)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

In the region A of the double-sided adhesive film 4, 50% in area ratio of the area on which the acrylic adhesive C and 100 mm square plate are adhered was peeled with a spatula by applying a force of 5 N. Out of the outer periphery of the region A of the double-sided adhesive film 4, with the portion to be pulled by the tensile tester as the center, the vicinity thereof was peeled. After that, the laminate was heated at 210°C for 60 seconds on a heater block, and thereafter, peeling properties were evaluated using the tensile tester. The evaluation results are shown in Table 3.

The stress when peeling with a spatula was calculated by the same method as Example 5. Here, the total peeling strength (N) required for the peeling is the strength required for peeling the region A, that is, the sum of the stress when peeled with a spatula and the peeling strength measured with the tensile tester after heating on a heater block.

(Example 8)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

In the region A of the double-sided adhesive film 4, 25% in area ratio of the area on which the acrylic adhesive C and 100 mm square plate are adhered was peeled with a spatula by applying a force of 5 N. Out of the outer periphery of the region A of the double-sided adhesive film 4, with the portion to be pulled by the tensile tester as the center, the vicinity thereof was peeled. After that, the laminate was heated at 210°C for 60 seconds on a heater block, and thereafter, peeling properties were evaluated using the tensile tester. The evaluation results are shown in Table 3.

The stress when peeling with a spatula was calculated by the same method as Example 5. Here, the total peeling strength (N) required for the peeling is the strength required for peeling the region A, that is, the sum of the stress when peeled with a spatula and the peeling strength measured with the tensile tester after heating on a heater block.

(Example 9)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

In the region A of the double-sided adhesive film 4, 12.5% in area ratio of the area on which the acrylic adhesive C and 100 mm square plate are adhered was peeled with a spatula by applying a force of 5 N. Out of the outer periphery of the region A of the double-sided adhesive film 4, with the portion to be pulled by the tensile tester as the center, the vicinity thereof was peeled. After that, the laminate was heated at 210°C for 60 seconds on a heater block, and thereafter, peeling properties were evaluated using the tensile tester. The evaluation results are shown in Table 3.

The stress when peeling with a spatula was calculated by the same method as Example 5. Here, the total peeling strength (N) required for the peeling is the strength required for peeling the region A, that is, the sum of the stress when peeled with a spatula and the peeling strength measured with the tensile tester after heating on a heater block.

(Comparative Example 4)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

The measurement sample was heated at 210°C for 60 seconds on a heater block, and thereafter, peeling properties were evaluated using the tensile tester. The evaluation results are shown in Table 3.

(Comparative Example 5)

The acrylic adhesive C side of the double-sided adhesive film 4 cut into a circle having a diameter of 84 mm was adhered on a 100 mm square plate (SUS304). Then, a circular plate with a diameter of 80 mm (Ni-plated steel) was adhered to the other side of the double-sided adhesive film 4 to obtain a laminate.

A measuring tool was attached to the laminate as shown in FIG. 4 to obtain a measurement sample.

The measurement sample was heated at 240°C for 120 seconds on a heater block, and thereafter, peeling properties were evaluated using the tensile tester. The evaluation results are shown in Table 3.

Table 3

|  | Peeling strength in peeling property evaluation (N) | Strength required for peeling (N) |
|---|---|---|
| Example 5 | 30 | 35 |
| Example 6 | 36 | 39.75 |
| Example 7 | 33 | 35.5 |
| Example 8 | 33 | 34.25 |
| Example 9 | 35 | 35.625 |
| Comparative Example 4 | Did not peel | - |
| Comparative Example 5 | 45 | 45 |

From the results of Examples 5 to 9, it was identified that only a small amount of energy is needed when the adhesive layer (17) in the region A is peeled in a predetermined area ratio in Step 1, but a lot more energy is required when the adhesive layer (17) is not peeled without performing Step 1 as shown in Comparative Examples 4 and 5.

The present application claims priority based on Japanese Patent Application No. 2013-115704, filed on May 31, 2013, and incorporate everything that has been disclosed in the patent application herein.

**Claims**

1. A method of peeling an electronic member (c) from a laminate composed of the electronic member (c) adhered to a supporting substrate (a) via an adhesive film (b), said adhesive film (b) having a self-peeling adhesive layer on a surface thereof located on the side of said supporting substrate (a) and an exposed region in at least one part of a surface thereof which is located on the side of said electronic member (c), the method comprising:

   a step of reducing adhesive strength between said supporting substrate (a) and said self-peeling adhesive layer by applying energy on said exposed region;
   a step of removing said supporting substrate (a) from the laminate by further applying energy on said region and thus further reducing the adhesive strength reduced in said prior step between said supporting substrate (a) and said self-peeling adhesive layer from a starting point of the interface between said supporting substrate (a) and said self-peeling adhesive layer; and
   a step of peeling said electronic member (c) from the laminate by removing said adhesive film (b) from said electronic member (c).

2. A method of peeling an electronic member according to claim 1, wherein said energy is any one selected from heat, light, vibration, stress and ultrasonic waves.

3. A method of peeling an electronic member according to claim 1 or 2, wherein said exposed region in which said adhesive film (b) is exposed exists along the entire outer edge of said electronic member (c).

4. A method of peeling an electronic member according to any one of claims 1 to 3, wherein said electronic member (c) is a silicon wafer, a ceramic capacitor or a semiconductor package.

5. A laminate comprising:

   a supporting substrate (a);
   an adhesive film (b); and
   an electronic member (c) adhered to said supporting substrate (a) via said adhesive film (b),
   wherein said adhesive film (b) has a self-peeling adhesive layer on a surface thereof which is located on the side of said supporting substrate (a) and an exposed region in at least one part of a surface thereof which is located on the side of said electronic member (c).

[FIG. 1]

[FIG. 2]

(a)

(b)

[FIG. 3]

( i )

16
} 14
12
17

( ii )

16
} 14
17
12

( iii )

16
14 {
17
12

[FIG. 4]

TENSILE TESTER

L-shaped JIG with magnet

Electronic Member 16

(Double-sided tape
for reinforcement)

Adhesive Film 14

Supporting Substrate 12

Adhesive Layer

Base Film

Adhesive Layer 17

Heat Block

## INTERNATIONAL SEARCH REPORT

| | International application No. |
|---|---|
| | PCT/JP2014/063578 |

**A.   CLASSIFICATION OF SUBJECT MATTER**
*H01L21/304(2006.01)i*

According to International Patent Classification (IPC) or to both national classification and IPC

**B.   FIELDS SEARCHED**

Minimum documentation searched (classification system followed by classification symbols)
H01L21/304

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| X | JP 2003-338474 A  (Lintec Corp.),<br>28 November 2003 (28.11.2003),<br>paragraphs [0001], [0004] to [0008], [0017] to [0023], [0026]; fig. 4, 7 to 8<br>(Family: none) | 1-5 |
| A | WO 2009/142078 A1  (Fuji Electric Device Technology Co., Ltd.),<br>26 November 2009 (26.11.2009),<br>entire text; all drawings<br>& JP 2011-40419 A        & US 2011/0129989 A1<br>& CN 102037553 A | 1-5 |

| ☒ | Further documents are listed in the continuation of Box C. | ☐ | See patent family annex. |
|---|---|---|---|

| | |
|---|---|
| *     Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| 05 August, 2014 (05.08.14) | 19 August, 2014 (19.08.14) |

| Name and mailing address of the ISA/<br>    Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2014/063578

C (Continuation).   DOCUMENTS CONSIDERED TO BE RELEVANT

| Category* | Citation of document, with indication, where appropriate, of the relevant passages | Relevant to claim No. |
|---|---|---|
| A | US 2011/0048611 A1  (Alain Robert Emile CARRE), 03 March 2011 (03.03.2011), entire text; all drawings & JP 2013-503366 A       & WO 2011/031507 A1 & TW 201115222 A         & CN 102625951 A & KR 10-2012-0061923 A | 1-5 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0543851 A
- JP H11166164 A
- JP 4238037 B
- JP 2003173993 A
- JP 5006497 B
- JP 2003151940 A
- JP 2001200234 A
- JP 2003173989 A
- US 8114766 B
- JP 2013115704 A